(19) Europäisches Patentamt
European Patent Office
Office européen des brevets

(11) **EP 2 482 287 A1**

(12) **EUROPEAN PATENT APPLICATION**

(43) Date of publication:
**01.08.2012 Bulletin 2012/31**

(51) Int Cl.:
**G11C 11/22** $^{(2006.01)}$

(21) Application number: **12153546.2**

(22) Date of filing: **01.02.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **01.02.2011 IT TO20110083**
**01.03.2011 IT TO20110182**

(71) Applicant: **STMicroelectronics Srl**
**20864 Agrate Brianza (IT)**

(72) Inventors:
• **Scalia, Antonio Maria**
**95125 CATANIA (IT)**
• **Greco, Maurizio**
**95021 Acicastello (IT)**

(74) Representative: **Jorio, Paolo et al**
**Studio Torta S.p.A.**
**Via Viotti, 9**
**10121 Torino (IT)**

(54) **Memory support provided with elements of ferroelectric material and improved non-destructive reading method thereof**

(57) A method for non-destructive reading of an information datum stored in a memory (10) that includes a first word line (18a), a first bit lines and a second bit lines, and a first ferroelectric transistor (14), which is connected between the bit liness and has a control terminal (20c) coupled to the first word line, the method comprising the steps of: applying to the first word line (18a) a first reading electric quantity (Vread); generating a first difference of potential (Vsense) between the first and second bit liness (16a, 17a); generating a first output electric quantity ($i_{TOT}$; $V_a$); applying to the first word line (18a) a second reading electric quantity ($V_{ref}$); generating a second difference of potential (Vsense) between the first and second bit liness (16a, 17a); generating a second output electric quantity ($i_{TOT}$; $V_b$); comparing the first and second output electrical quantities ($V_a$, $V_b$) with one another; and, on the basis of a result of said comparison, determining the logic value of the information datum.

Fig.2

## Description

The present invention relates to a memory provided with elements of ferroelectric material and to a non-destructive reading method thereof.

As is known, in the context of storage systems the need is felt to reach high storage capacities with high data-transfer rates (bitrates), at the same time reducing the manufacturing costs and the occupation of area. Storage systems currently most widely used, namely, hard-disk drives (with miniaturized dimensions) and flash RAMs, present intrinsic technological limits as regards increase of the data-storage capacity and of the read/write speed, and reduction of their dimensions.

Amongst the innovative solutions proposed, very promising are storage systems that use a storage medium of ferroelectric material, in which reading/writing of individual bits is made by interacting with the ferroelectric domains of the ferroelectric material.

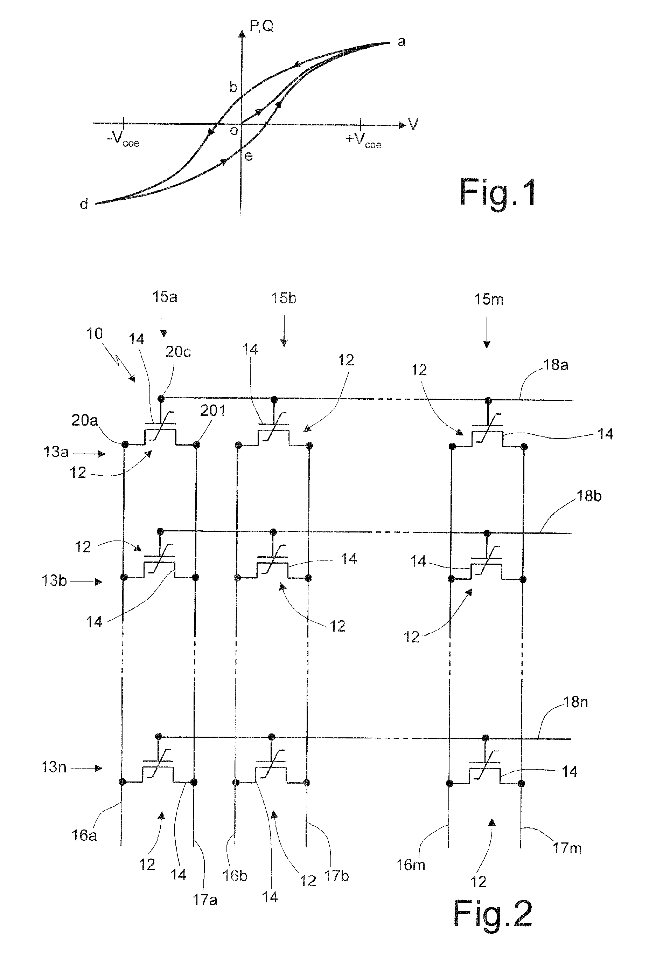

As is known, a ferroelectric material possesses a spontaneous polarization, which can be reversed by an applied electrical field. As shown in Figure 1, said material moreover presents a hysteresis cycle in the diagram of the polarization charge Q (or, equivalently, of the polarization P) as a function of the applied voltage V, exploiting which it is possible to store information in the form of bits. In particular, in the absence of a biasing voltage imparted on the medium (V = 0), there exist two points of the diagram in the stable state (designated by "b" and "e") that have different polarization, in particular equal and opposite. Said points can remain in the stable state even for some years, thus maintaining the binary datum stored (for example, point "b", with positive charge $+Q_H$, corresponds to a "0", whereas point "e", with negative charge $-Q_H$, corresponds to a "1").

The writing operations envisage application to the ferroelectric medium of a (positive or negative) voltage higher than a coercive voltage Vcoe characteristic of the ferroelectric material. In this case, stored in the material is a positive charge $+Q_H$, or negative charge $-Q_H$ (this basically corresponds to a displacement along the diagram from point "e" to point "b" passing through point "a", or else from point "b" to point "e" passing through point "d"). A voltage having an absolute value that is lower than the coercive voltage Vcoe does not, instead, cause a stable variation of the charge stored.

The data-reading techniques commonly used are based on a destructive operation, which envisages erasure of the data read. In summary, a (positive or negative) voltage having an amplitude greater than that of the coercive voltage Vcoe is applied to the ferroelectric material, thus performing in practice a writing operation, and the occurrence or otherwise of a reversal of polarity of said ferroelectric material is detected. For this purpose, the existence or otherwise of an appreciable current that flows in the ferroelectric material is detected. Clearly, the application of a positive (or negative) voltage causes reversal of just the ferroelectric domains in which a negative charge $-Q_H$ (or positive charge $+Q_H$) has previously been stored.

The main problem of said reading technique is linked to the fact that the reading operations are destructive; i.e., they imply removal of the information stored previously and hence the impossibility of carrying out subsequent readings of the data themselves, without there having previously been carried out a re-writing of the data read. In fact, reading of a portion of the memory corresponds to writing in said memory portion of a sequence of charges that are all positive (or all negative, in the case where a negative reading voltage is used). Consequently, during reading the flow of the data read must be stored in a memory buffer, and a writing operation is then necessary for restoring the original information.

Said reading technique entails a considerable expenditure of time and power, and basically constitutes a bottleneck for current ferroelectric storage systems, in particular as regards bitrate.

In order to overcome said problem some techniques of non-destructive reading of the data stored have been proposed.

For example in Cho et al., "Terabit inch-2 ferroelectric data storage using scanning nonlinear dielectric microscopy nanodomain engineering system", Nanotechnology No. 14, 2003, 637-642, Institute of Physics Publishing, a sinusoidal signal is applied to a ring electrode, which induces an oscillation in a resonant circuit that includes the ferroelectric medium in which the information bit is stored. A demodulator detects the harmonics of the induced oscillation, the phases of which are correlated to the information bit stored, on account of the different behaviour of the high-order nonlinear permittivities of the ferroelectric material in the stable points of the polarization diagram.

In Kato et al., "0.18-$\mu$m nondestructive readout FeRAM using charge compensation technique", IEEE Transactions on electron devices, Vol. 52 No. 12, December 2005, a reading circuit is described, which envisages connection in series of a ferroelectric capacitor (constituted by the storage medium) to the gate terminal of a reading MOS transistor. By applying a reading pulse, the charge stored in the capacitor biases the gate terminal of the MOS transistor, in a different way according to the polarization state stored previously, thus varying the conductivity of the conduction channel thereof. Next, the datum stored is read by detecting the current that flows between the current-conduction terminals of the transistor itself, in a static way, by means of a sense amplifier.

The aforesaid reading techniques, albeit presenting the advantage of not being destructive and hence not requiring re-writing of the data read, are not altogether satisfactory as regards the constructional complexity and their operation.

Other documents that describe memories comprising ferroelectric elements and corresponding read/write methods are the patents Nos. US 5,086,412, US 6,819,583, and US 4,888,733. However, each of the memory cells according to said documents comprises one or more transistors for direct addressing of the memory cell, and at least one additional ferroelectric capacitor for storage of the charge that represents the logic information (bit "1" or bit "0") to be stored.

Also these solutions are not optimal in terms of occupation of area and operation. For example, some of these memories present problems of coupling between adjacent cells during the writing operations.

The aim of the present invention is to provide a memory having elements made of ferroelectric material, and a corresponding non-destructive reading method that will enable the aforementioned problems and disadvantages to be overcome.

According to the present invention a memory having elements made of ferroelectric material and a corresponding non-destructive reading method are consequently provided, as defined in the annexed claims.

For a better understanding of the present invention, preferred embodiments thereof are now described, purely by way of nonlimiting example and with reference to the attached drawings, wherein:

- Figure 1 is a plot representing a hysteresis cycle of a ferroelectric material of a storage medium;

- Figure 2 shows a portion of a memory in which each memory cell is formed by a single FeFET;

- Figures 3a-3c show embodiments that are alternative to one another of FeFETs that can be used in the memory portion of Figure 2;

- Figure 4 shows an example of transcharacteristic curve for a generic FeFET;

- Figure 5 shows steps of a method for non-destructive reading of memory cells of the memory portion of Figure 2, according to the present invention;

- Figure 6 shows the memory portion of Figure 2 during a reading step according to the method of Figure 5;

- Figures 7a and 7b show the plots of voltage signals used for the steps of reading of a memory cell according to the method of Figure 5;

- Figure 8 represents the transcharacteristic curve of the FeFET of Figure 2, which shows a variation of output current of the FeFET as a function of the voltage signals used for the reading steps according to the method of Figure 5;

- Figures 9a-9d show the plots of voltage signals used for the steps of reading of "n" memory cells, according to the method of Figure 5;

- Figures 10a-10f show a comparator circuit, according to one embodiment of the present invention;

- Figures 11a-11d show a comparator circuit, according to another embodiment of the present invention;

- Figures 12a-12d show a comparator circuit, according to a further embodiment of the present invention;

- Figures 13a-13d show the plots of voltage signals used for the steps of reading of "n" memory cells, according to a reading method alternative to the method of Figure 5;

- Figures 14a and 14b show a comparator circuit that can be used for implementing the method of Figures 13a-13d;

- Figure 15 shows a memory block according to the present invention; and

- Figure 16 shows a connection topology that can be used for implementing a column or row selector of the memory block of Figure 15.

Designated by the reference number 10 in Figure 2 is a portion of a memory (not shown as a whole) comprising a plurality of memory cells 12 arranged to form an array having a plurality of rows 13a, 13b,..., 13n (defined by a plurality of respective word lines) and a plurality of columns 15a, 15b,..., 15m (defined by a plurality of respective pairs of bit liness). It is evident that the memory portion 10 can comprise any number of rows and columns. In general, the memory portion 10 defines an array of memory cells 12 of dimensions (rows·columns) equal to n·m, with n and m integer numbers chosen as desired.

Each memory cell 12 comprises an electronic device having the function of co-operating in the selection of the respective memory cell 12 (for the steps of reading/writing of the respective memory cell) and of the element for storage of data (in particular, a logic datum "1" or "0"). In the following description the logic value "1" identifies a high logic value, whereas the logic value "0" identifies a low logic value. The voltage levels associated to the logic values "1" and "0" depend upon the physical structure of the components used, and their exact value is indifferent for the purposes of the present invention.

According to one embodiment of the present invention, the electronic device is a transistor 14, in particular of a FeFET (ferroelectric field-effect transistor) type. The memory cell 12 thus formed, comprising a single FeFET is also known as "1T" memory cell.

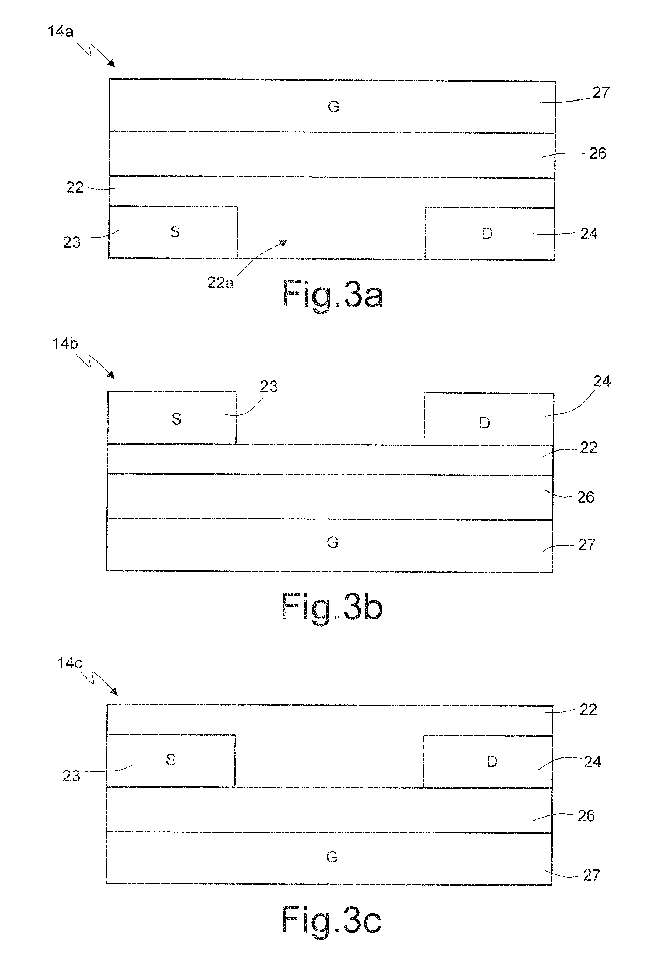

Each transistor 14 (see also Figures 3a-3c) has a first conduction terminal (source terminal) 20a, a second conduction terminal (drain terminal) 20b, and a control terminal (gate terminal) 20c. The transistors 14 belonging to one and the same column 15a-m have the respective first conduction terminals 20a connected to one and the same first bit lines 16a, 16b,..., 16m, and the respective second conduction terminals 20b connected to one and the same second bit lines 17a, 17b, ..., 17c. In this way, for each column 15a-m, the transistors 14 are connected to one another in parallel.

For each row 13a-n, the control terminals 20c of each transistor 14 are connected to one and the same word line18a, 18b, ..., 18n.

Figures 3a-3c show embodiments that are alternative to one another of a FeFET that can be used as memory cell 12 of the memory portion 10 of Figure 2, in particular a single-transistor (1T) memory cell. FeFET transistors designed to form 1T memory cells are, for example, known from US 6,091,621 and US 6,335,550.

In particular, Figure 3a shows, in cross-sectional view, a transistor 14a of a FeFET type with a structure of a top-gate type. The transistor 14a comprises: a semiconductor layer 22 made, for example, of organic material such as pentacene, anthracene, rubene, or organic polymers, or, alternatively, of inorganic semiconductor material; a first conduction terminal 23, made of conductive material, designed to form a source terminal of the transistor 14a, extending partially in the semiconductor layer 22; a second conduction terminal 24, made of conductive material, designed to form a drain terminal of the transistor 14a, extending partially in the semiconductor layer 22 at a distance from the first conduction terminal 23 and laterally in contact with the first conduction terminal 23 by means of a portion of the semiconductor layer 22; a ferroelectric layer 26, preferably made of organic polymeric ferroelectric material (for example, polyvinylidene fluoride - P(PVDF-TrFE)), formed in contact with the semiconductor layer 22 and separated from the first and second conduction terminals 23, 24 by means of the semiconductor layer 22; and a control terminal 27 (gate terminal), made of conductive material, extending on, and in contact with, the ferroelectric layer 26. In this way, the ferroelectric layer 26 extends between the control terminal 27 and the semiconductor layer 22 in which the first and second conduction terminals 23, 24 are formed. The ferroelectric layer 26 has, in use, the function of memory element designed to store the logic datum that is to be stored. The transistor 14a can be used in the memory portion 10 of Figure 2 to form the memory cell 12. In this case, the first conduction terminal 23 corresponds to the terminal 20a, the second conduction terminal 24 corresponds to the terminal 20b, and the control terminal 27 corresponds to the terminal 20c of the transistor 14 of Figure 2.

In order to operate the transistor 14a as memory element, in particular for writing a logic datum in the memory element, a voltage is applied between the control terminal 27 and both of the conduction terminals 23, 24 in order to modify the state of polarization of the ferroelectric layer 26. By setting a pre-set and known state of polarization of the ferroelectric layer 26 the operation of writing of the logic datum is carried out. In particular, a first polarization state is associated to a first logic value, whereas a second polarization state is associated to a second logic value. As is known, the polarization state set remains in the ferroelectric layer 26 even following upon removal of the applied voltage.

In order to read a logic datum stored in the memory element formed by the transistor 14a, a voltage is applied across the first and second conduction terminals 23, 24, and the current that flows between the terminals 23, 24 is detected. The current that flows between the first and second conduction terminals 23, 24 is affected by the state of polarization of the ferroelectric layer 26, and the current value detected can thus be associated to the logic value stored. With reference to Figure 3a, the portion of the semiconductor layer 22 comprised between the first and second conduction terminals 23, 24 has, in use during reading operations, the function of channel region of the transistor 14a, in which the charge carriers flow.

Figure 3b shows, in cross-sectional view, a transistor 14b of a FeFET type, having a structure of a bottom-gate/top-contact type. The transistor 14b of Figure 3b comprises, in a way similar to the transistor 14a of Figure 3a (elements that are in common are designated by the same reference numbers): the control terminal 27, made of conductive material, having the function of gate terminal of the transistor 14b; the semiconductor layer 22; the layer of ferroelectric material 26, preferably made of organic polymeric ferroelectric material, which extends between the semiconductor layer 22 and the control terminal 27; the first conduction terminal 23, which extends on top of and in electrical contact with the semiconductor layer 22; and the second conduction terminal 24, which extends on top of and in electrical contact with the semiconductor layer 22, at a distance from the first conduction terminal 23. The embodiment of Figure 3b differs from the embodiment of Figure 3a in so far as the first and second conduction terminals 23, 24 do not extend within the semiconductor layer 22, but on top of it. Operation of the transistor 14b, for the operations of writing and reading of a logic datum, is similar to what has been described with reference to the transistor 14a of Figure 3a, and the transistor 14b can hence be used as memory cell 12 in the memory portion 10 of Figure 2.

Figure 3c shows, in cross-sectional view, a transistor 14c of a FeFET type, having a structure of the bottom-gate type, according to a further embodiment alternative to the one shown in Figures 3a, 3b. The transistor 14c of Figure 3c has a structure similar to that of the transistor 14b of Figure 3b, but differs from the latter on account of the presence of a semiconductor layer 22, which extends underneath, between, and on top of the first and second contact terminals 23, 24. In order to access the first and second conduction terminals 23, 24 appropriate contacts (not shown) must be formed, which extend through the portion of the semiconductor layer formed on top of the first and second conduction terminals 23, 24. Operation of the transistor 14c, for the operations of writing and reading of a logic datum, is similar to what has been described with reference to the transistor 14a of Figure 3a, and the transistor 14c can hence be used as memory cell 12 in the memory portion 10 of Figure 2.

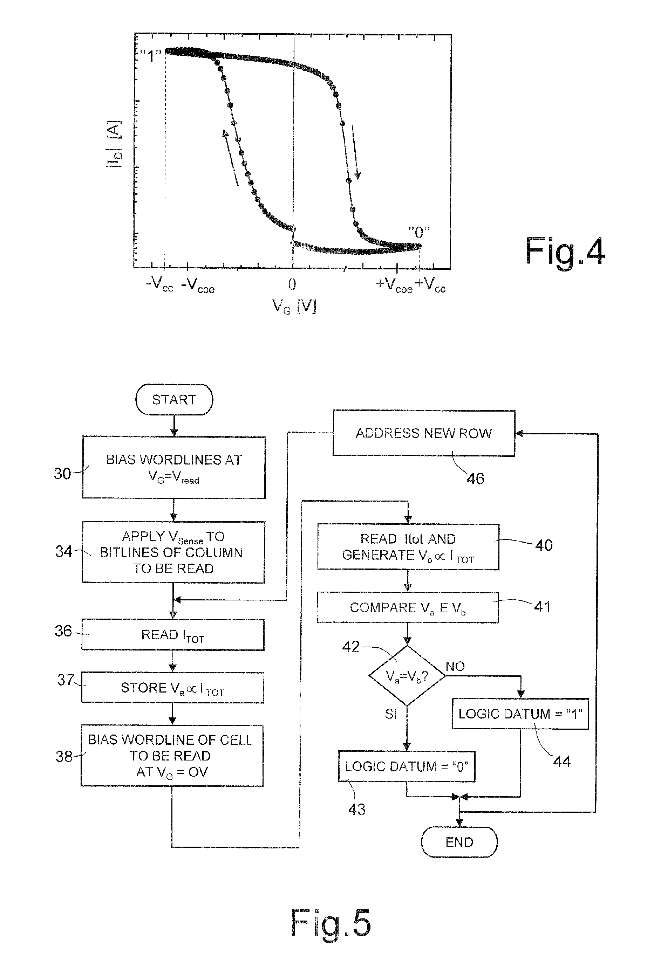

Figure 4 shows a transcharacteristic curve typical of a FeFET. The axis of the abscissae represents the voltage $V_G$ applied to the gate terminal of the FeFET, whilst the axis of the ordinates (in logarithmic scale) represents the current $I_D$ that flows between the source terminal and the drain terminal as the voltage $V_G$ varies when a potential difference is applied across them. A voltage value $V_G \approx Vcc > Vcoe$ corresponds to the voltage that is necessary for setting a first stable polarization state of the ferroelectric material of the FeFET, corresponding to a current value $I_D$ that is minimum (in absolute value) and can be associated to the low logic value ("0"); a voltage value $V_G \approx (-Vcc) < (-Vcoe)$ corresponds to the voltage that is necessary for setting a second stable polarization state of the ferroelectric material of the FeFET (different from the first polarization state), corresponding to a current value $I_D$ that is maximum (in absolute value) and can be associated to the high logic value ("1"). It is evident that the association between the minimum and maximum current values $I_D$ and, respectively, the low logic value "0" and the high logic value "1" is purely conventional. The reverse association is possible so that the current value $I_D$ that is minimum (in absolute value) can be associated to the high logic value "1", and the current value $I_D$ that is maximum (in absolute value) can be associated to the low logic value "0".

The transition between the two polarization states follows a hysteresis curve, as already discussed with reference to Figure 1 and also shown in Figure 4.

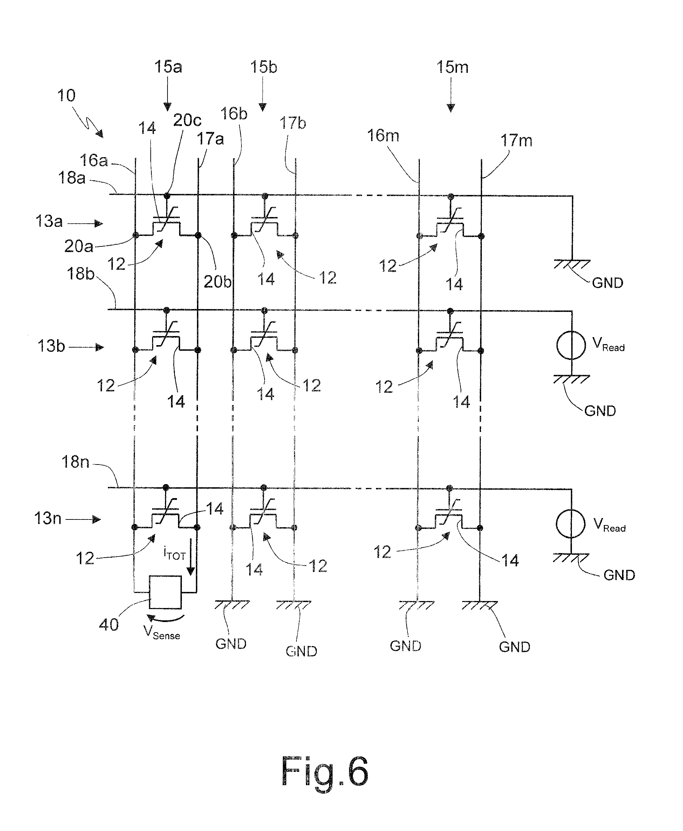

Figure 5 shows, by means of a flowchart, steps of a method for non-destructive reading of the memory portion 10 of Figure 2. Figure 6 illustrates the memory portion 10 during reading of a memory cell 12, representing voltage signals applied to the bit liness and to the word lines for reading the memory cell 12 selected.

It is assumed, with reference to Figure 6, that the memory cell 12 to be read is the memory cell 12 set at the intersection between the row 13a and the column 15a.

In step 30 of Figure 5, all the word lines 18a-n are biased at the reading voltage Vread such that $0 < |Vread| < |Vcoe|$. In other words, all the gate terminals 20c of the transistors 14 connected to the word lines 18a-n are biased at a voltage higher than 0 V and such as not to be higher than the coercive voltage Vcoe (which, as has been said, is positive or negative according to the logic datum written in the memory cell 12). In fact, if the coercive voltage Vcoe were to be exceeded ($|Vread| > |Vcoe|$), the memory cell 12 would be rewritten. Then (step 34), by applying an appropriate voltage Vsense between the bit liness 16a, 17a, it is possible to carry out an operation of detection of the current that flows between the source terminals 20a (connected to the bit lines 16a) and the drain terminals 20b (connected to the bit lines 17a) of the transistors 14 belonging to the column 15a. The voltage Vsense has a value such that Vsense « Vcoe, or, rather, $|Vsense| + |Vread| < |Vcoe|$. Still more precisely, one should have:

$$\begin{cases} |Vread - Vdrain| < |Vcoe| \\ |Vread - Vsource| < |Vcoe| \\ Vdrain - Vsource = Vsense \end{cases}$$

where Vdrain and Vsource are the voltages applied, through respective bit liness, to the drain terminal 20b and source terminal 20a, respectively, of the transistor 14 to be read. The remaining bit liness 16b-m, 17b-m are biased at ground voltage (e.g., 0 V).

Each transistor 14 belonging to the addressed column 15a shows a channel resistance of a high or low value, according to the state of polarization of the ferroelectric layer, corresponding to the logic value "0" or "1" stored (see Figure 4). The current that flows between the source terminal 20a and the drain terminal 20b of each transistor 14 is hence a function of the voltage applied to the respective gate terminal 20c and of the state of polarization of the ferroelectric layer. The current $i_{TOT}$ that flows between the bit liness 16a and 17a is hence the total current that flows through all the transistors 14 (connected in parallel to one another) belonging to the column 15a and is not indicative, considered in itself, of the logic value stored in the memory cell 12 that is to be read. Said total current $i_{TOT}$ is read during step 36. As described more fully hereinafter, according to one embodiment of the present invention, the value of total current $i_{TOT}$ read during step 36 is converted into a corresponding voltage value $V_a$, which is stored (step 37), for example by charging a capacitor.

Biasing of the bit liness at a voltage Vsense and reading of the total current $i_{TOT}$ are made by means of an appropriate circuit for biasing and reading of the current, as shown schematically in Figure 6 and designated by the reference number 40.

Then (step 38), the biasing voltage of the word line 18a (or, in general, of the word line connected to the gate terminal of the transistor 14 that is to be read) is varied from Vread to 0 V.

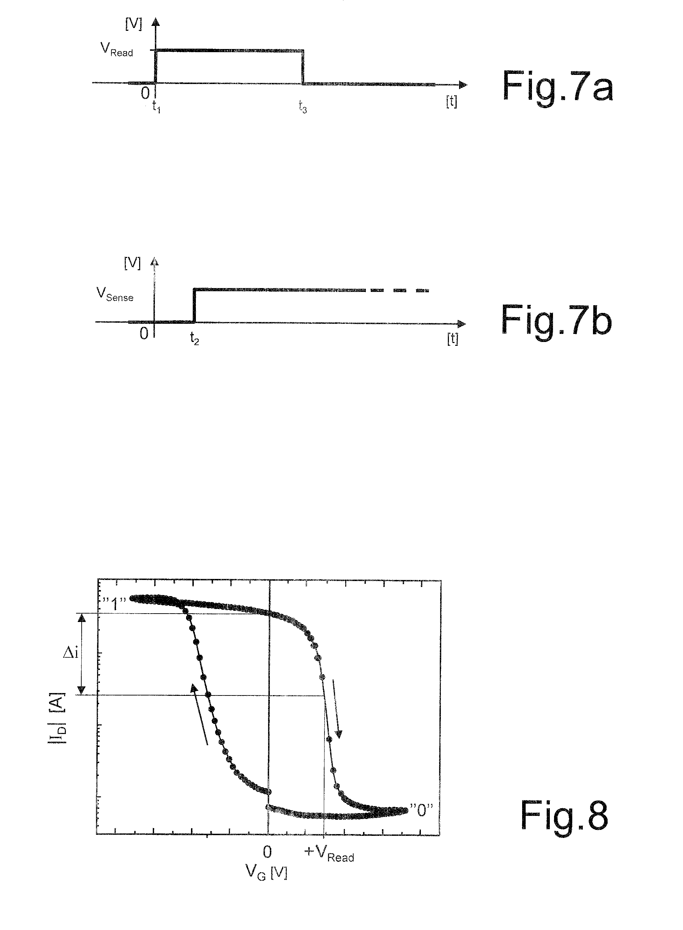

Figures 7a and 7b show schematically the time plot of the signals used for biasing the bit liness 16a, 17a (signal Vsense) and the word line 18a (signal Vread) for reading the transistor 14, the gate terminal of which is connected to the word line 18a and the source and drain terminals of which are connected to the word lines 16a and 17a. The voltage Vread applied to the word line 18a (Figure 7a) has a boxcar waveform, with rising edge at time t1 = 0 and falling edge at time t3. The temporal duration of the boxcar waveform (t1-t3 on the axis of the abscissae) is, for example, of some milliseconds, whilst the amplitude in voltage (axis of the ordinates) is of some volts (for example, between 3 and 10 V). It is to be noted, however, that these values are purely indicative and can vary according to the physical characteristics of the transistors 14 used.

The voltage Vsense applied to the bit liness 16a, 17a (Figure 7b) has a rising edge at time t2, of a value comprised between t1 and t3. The time interval t1-t2 is chosen so as to be longer than the transient for obtaining a correct biasing of the gate terminal 20c of the transistor 14 of the memory cell 12 to be read. The duration of application of the voltage Vsense to the bit liness 16a, 17a is defined on the basis of the number of memory cells 12 to be read belonging to the column that is being read, here the column 15a. In general, the voltage Vsense is applied to a column 15a-m until all the memory cells 12 that are to be read, belonging to that particular column 15a-m, have been read. Alternatively, the voltage Vsense is applied, for reading each memory cell 12, for a time interval limited to the time necessary for the reading itself.

The remaining bit liness 16b-m, 17b-m (which are not to be read) are biased at ground voltage (e.g., 0 V).

As may be noted from the curve of Figure 4, for voltages applied to the gate terminals 20c of the transistors 14 equal to 0 V, there is a non-zero passage of current between the respective source terminal 20a and drain terminal 20b. The value of the current that flows for zero gate voltages depends upon the state of polarization of the ferroelectric layer of each respective transistor 14 (i.e., upon the logic datum stored). For example, if in the memory cell 12 a logic value "0" is stored, the current $I_D$ that flows between the source terminal 20a and the drain terminal 20b has a low value (indicatively, a fraction of nanoamps, e.g. 0.7nA); otherwise, in the case where a logic value "1" is stored, the current $I_D$ has a high value (indicatively, some tens of nanoamps, e.g. 80nA). It is evident that the exact values of the current $I_D$ depend upon the structure and upon the type of FeFET used, and can vary on the basis of the operating conditions (e.g., temperature of use) and/or for reasons linked to the steps for manufacture of the FeFETs (for example, the thicknesses of the layers, the doping values, the process spread, etc.).

It is moreover evident that as we move away from the zero value of voltage on the gate $V_G$, said values vary. In this regard, when in the memory cell 12 a logic value "1" is stored (condition of channel with low electrical resistance), and a voltage is applied on the gate equal to $V_G$ = Vread (e.g., Vread = 5V), it is possible to note a variation of the current that flows between the source and drain terminals for the transistor 14 of that memory cell 12 (for example, the current drops from approximately 80 nA to 40 nA).

Reference may be made, for example, to Figure 8. From the transcharacteristic curve of the output current of the FeFET it may be noted that the current value ($I_D$) drops significantly (by a term $\Delta i$) by increasing the voltage on the gate beyond the value $V_G$ = 0 V (if we consider that the axis of the abscissae is in logarithmic scale said variation is even more evident than what may be appreciated from Figure 8). It should moreover be noted that, given the same voltage Vread, the variation of current $I_D$ is instead evident when in the memory cell 12 a logic value "0" is stored (condition of channel with high electrical resistance).

To return to step 38 of Figure 5, the variation of the biasing of the gate terminal of the transistor that is being read from $V_G$ = Vread to $V_G$ = 0 V has, on the total current $i_{TOT}$, two different effects according to whether the logic value stored in the transistor 14 is a "1" or a "0". If the logic value is a "0", the variation of voltage on the gate from Vread to 0 V does not cause a significant variation of total current $i_{TOT}$; instead, if the logic value is a "1", the variation of voltage on the gate from Vread to 0 V causes a significant variation of total current $i_{TOT}$ (for example, 50%; however, this percentage value may differ according to the value chosen for Vread and to the output transcharacteristic curve of the transistor 14).

Next (step 40) a new reading is carried out of the current value $i_{TOT}$ generated as a consequence of the variation of the word line biasing value.

The new current value $i_{TOT}$ detected according to step 40 is converted into a corresponding voltage value $V_b$ and supplied at input to a first input of a comparator. The second input of the comparator receives the voltage value $V_a$ correlated to the value of total current $i_{TOT}$ acquired previously (step 36) and stored during step 37. The comparator carries out a comparison (step 41) between the values of the two voltages $V_a$ and $V_b$ that it receives at input and supplies at output a result of said comparison.

On the basis of the result of the comparison, a check is made to establish (step 42) whether the value of total current $i_{TOT}$ acquired in step 36 has remained substantially unvaried with respect to the value of total current $i_{TOT}$ acquired in step 40, or else whether the two values are markedly different from one another.

The comparator is configured for comparing two voltages ($V_a$ and $V_b$), the difference between which $\Delta V = V_a - V_b$ is proportional to $\Delta i$. It follows that the comparison threshold of the comparator can be set at a value equal to $\Delta V/2$, proportional to $\Delta i/2$. In this case, two voltages $V_a$ and $V_b$ that differ from one another for a value lower than $\Delta V/2$ are considered the same as one another. Alternatively, to guarantee greater immunity to noise, it is possible to define an indecision range ($\Delta V/2 \pm \Delta_{ind}$) around the value $\Delta V/2$. Consequently, two voltages $V_a$ and $V_b$ that differ from one another for a value lower than $\Delta V/2 - \Delta_{ind}$ are considered the same as one another; instead, two voltages $V_a$ and $V_b$ that differ from one another for a value higher than $\Delta V/2 + \Delta_{ind}$ are considered different from one another. Values comprised in the range $\Delta V/2 \pm \Delta_{ind}$ are considered indeterminate (in this case the reading can be carried out again, or else a reading-error message can be generated, etc.).

The value of $\Delta i$ is set by the technology of the transistor 14. On the basis of the transistor 14 used, the current-to-voltage conversion circuit and the comparator must be chosen in such a way as to guarantee at the same time a sufficient immunity to noise and an adequate sensitivity to the variations of total current $i_{TOT}$ caused by the variation of the value of biasing voltage of the gate terminal 20c of the transistor 14 that is being read.

It may hence be concluded that, if the value of total current $i_{TOT}$ acquired in step 36 has remained substantially unvaried with respect to the value of total current $i_{TOT}$ acquired in step 40, then the logic value stored in the transistor 14 that is being read is "0" (step 43, output YES from step 42); otherwise, the logic value stored is "1" (step 44, output NO from step 42).

Then, reading of the next memory cell 12 is carried out. In particular, to speed up the reading operations, it is preferable to read in sequence the memory cells 12 belonging to one and the same column and then, once the complete column has been read, pass on to the next column. Moreover, during reading of the memory cells 12 belonging to one and the same column 15a-m, the gate terminal of the transistor 14 that has previously been read remains biased at $V_G = 0$ V.

After step 43 or step 44 control hence returns to step 36, passing through step 46 for addressing a new row.

Figure 5 shows the steps for reading a column 15a-m. During reading of a memory array, it is in any case expedient to check whether the end of column has been reached (this step is not shown in Figure 5). If it has been reached (all the memory cells of interest of a given column have been read), both of the bit liness of that column are biased at a ground reference voltage, and a new column is addressed (or reading terminates if there are no further columns to be read).

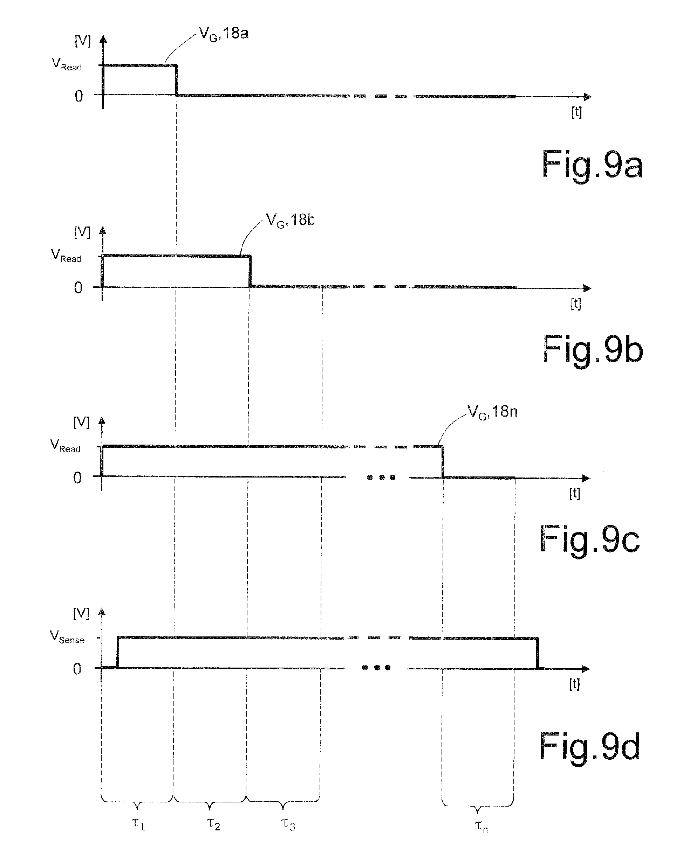

Figures 9a-9d show, in graphic form, the method for biasing the "n" word lines in the time "$\tau$", for reading a column 15am. As may be noted, in a first time interval $\tau_0$ all the word lines 18a-n are biased at a voltage Vread (pre-reading state). Then, the biasing voltage of the word line 18a is varied from the value Vread to the value 0 V, whilst the remaining word lines 15b-n are kept at the value Vread (interval $\tau_1$). Reading of the first memory cell 12 occurs by comparing the value of total current $i_{TOT}$ acquired during the interval $\tau_0$ with the value of total current $i_{TOT}$ acquired during the interval $\tau_1$. Reading of the first memory cell 12 is thus concluded, and the next memory cell 12 can be read. During the interval $\tau_2$ also the voltage applied to the second word line 18b is varied from the value Vread to the value 0 V, whilst the remaining word lines (except for the word line 18a corresponding to the memory cell already read, which maintains the biasing at $V_G = 0V$) are biased at the value Vread. Reading of the second memory cell 12 occurs by comparing the value of total current $i_{TOT}$ acquired during the interval $\tau_1$ with the value of total current $i_{TOT}$ acquired during the interval $\tau_2$. The procedure is repeated in this way for all the word lines associated to the memory cells 12 that are to be read. In general, for the n-th memory cell 12, the value of total current $i_{TOT}$ acquired during the time interval $\tau_{n-1}$ (when the gate terminal of the transistor 14 of the memory cell 12 that is being read is biased at $V_G = $ Vread) is compared with the value acquired during the time interval $\tau_n$ (when the gate terminal of the transistor 14 of the memory cell 12 that is being read is biased at $V_G = 0$ V). As has already been said, if the value of total current $i_{TOT}$ acquired during the time interval $\tau_{n-1}$ remains substantially unvaried also during the time interval $\tau_n$, then the logic value stored in the memory cell 12 that is being read is equal to "0"; otherwise, it is equal to "1".

As shown in Figure 9d, the voltage Vsense is applied to the bit liness of the column 15a-m that is being read for the entire duration of the reading operation.

According to a further embodiment of the present invention, reading of the memory cells 12 belonging to different columns 15a-m may be performed simultaneously. In fact, a voltage $V_G = 0$ V (or, likewise at $V_G = $ Vread) that biases a word line 18a-n biases all the gate terminals of all the transistors 14 belonging to one and the same row 13a-n.

By coupling a circuit for biasing and reading of the current 40 to each of the bit liness 16a-m, 17a-m of each column 15am, it is possible to bias at a voltage Vsense all the bit liness simultaneously and hence read simultaneously the values of current $i_{TOT}$ for each column 15a-m. There is in this case the advantage of being able to carry out a reading of the entire memory portion 10 in shorter times as compared to the solution that adopts a single reading circuit.

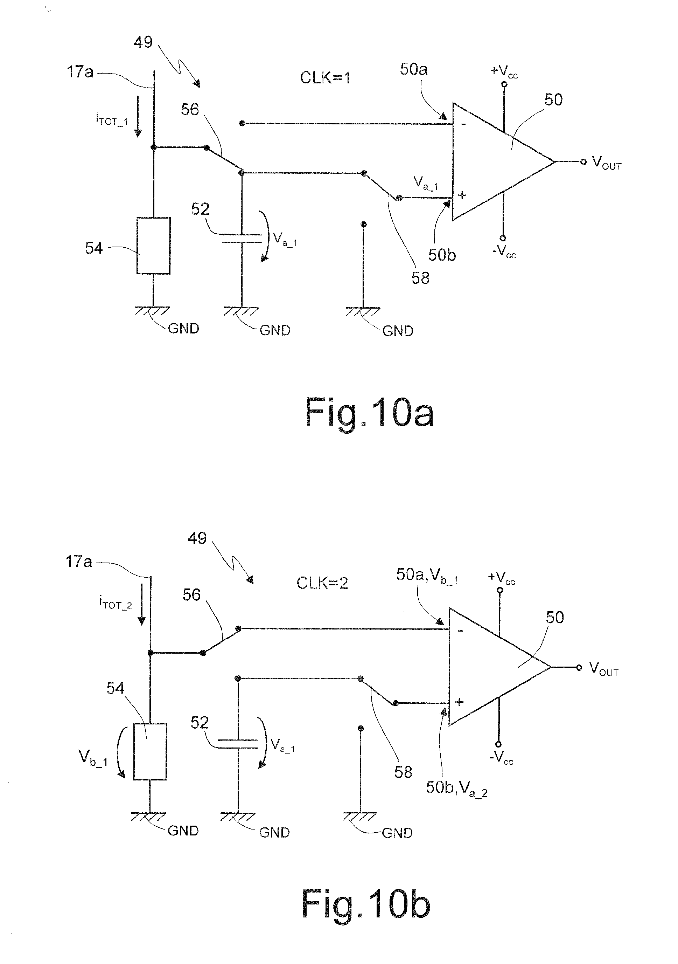

Figures 10a-10f are graphic representations of some of the steps of the reading method of Figure 5 (storage and comparison of the voltage values $V_a$ and $V_b$ associated to the values of total current $i_{TOT}$ acquired in successive instants), to provide a better illustration of the circuit operation of the memory according to the present invention.

The steps described are graphically shown using a schematic circuit representation, in which a comparison circuit 49 comprises: a bit lines 17a-m belonging to the column 15a-m that is being read (in particular, in this example, the bit lines 17a); a comparator 50, having a first input 50a and a second input 50b; a ground-reference terminal GND; a capacitor 52; a resistor 54, having a resistance R (of a value chosen appropriately according to the currents considered and to the application), connected between the bit lines 17a and the ground reference GND; a first switch 56 (for example, provided in bipolar or CMOS technology, but other technologies, such as organic technology, may be adopted); and a second switch 58 (which is also, for example, provided in bipolar or CMOS technology, but other technologies, such as organic technology, may be adopted).

The first switch 56 can be operated for coupling the bit lines 17a alternatively to the first input 50a of the comparator 50 and to a first terminal of the capacitor 52. A second opposite terminal of the capacitor 52 is connected to ground GND. The second switch 58 can be operated for coupling the first terminal of the capacitor 52 alternatively to the ground-reference terminal GND and to the second input 50b of the comparator 50.

The operations of switching of the first and second switches 56, 58 are carried out with a temporal cadence defined by a clock signal CLK.

It is now assumed that we are at the end of the step 34 of Figure 5. In this case, a current $i_{TOT\_1}$ flows in the bit lines 17a. The current $i_{TOT\_1}$ is converted into the voltage value $V_{a\_1}$ by means of the resistor 54 (in a way in itself known).

With reference to Figure 10a, the first switch 56 is operated so as to couple the bit lines 17a electrically to the first terminal of the capacitor 52; the second switch 58 is operated so as to couple the first terminal of the capacitor 52 electrically to the second input 50b of the comparator 50. During this step, the capacitor 52 is charged at a voltage $V_{a\_1}$ proportional to the current $i_{TOT\_1}$ that flows in the bit lines 17a ($V_{a\_1} = R \cdot i_{TOT\_1}$ at a time defined by the clock signal CLK = 1). In this way, step 37 of Figure 5 is completed.

Then, step 38 of Figure 5 is carried out, and control goes to step 40. During this step, a voltage value $V_{b\_1}$ is generated proportional to the current $i_{TOT\_2}$ that flows in the bit lines 17a ($V_{b\_1} = R \cdot i_{TOT\_2}$ at the time defined by the clock signal CLK = 2).

Next, the comparison described by steps 41-44 of Figure 5 is carried out.

With reference to Figure 10b, the first switch 56 is operated so as to couple the bit lines 17a electrically to the first input 50a of the comparator 50, whilst the second switch 58 is operated so as to couple the first terminal of the capacitor 52 electrically to the second input 50b of the comparator 50. The voltage value $V_{a\_1}$ proportional to the total current $i_{TOT\_1}$ at time CLK = 1 is compared with the voltage value $V_{b\_1}$ proportional to the total current $i_{TOT\_2}$ at time CLK = 2. The signal $V_{out}$ at output from the comparator 50 is used as described previously for evaluating the logic value of the datum stored in the memory cell 12 that is being read.

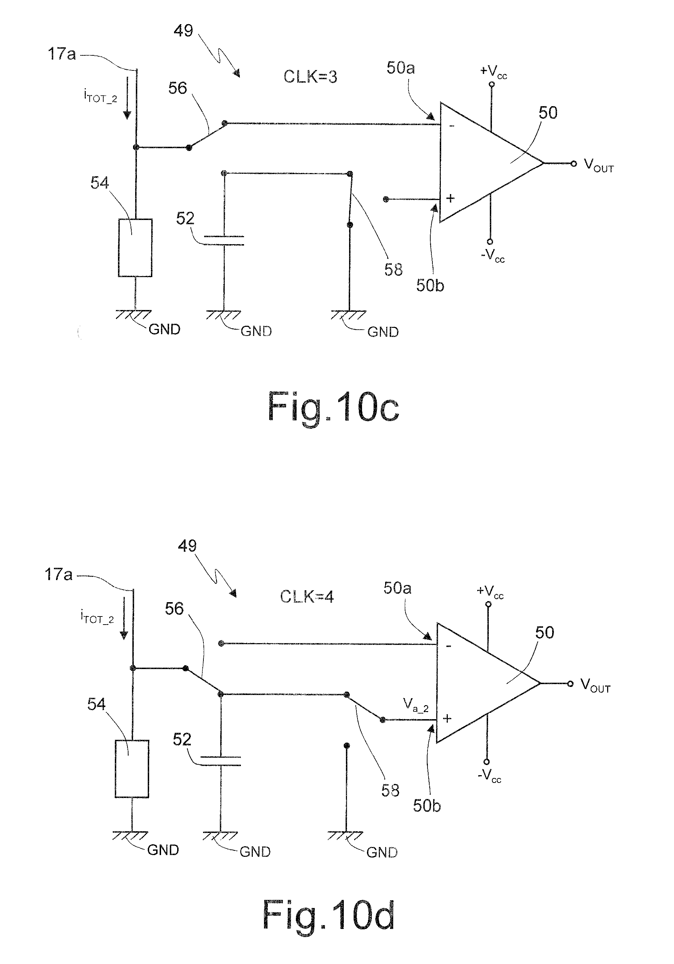

In order to carry out reading of a new memory cell 12, it is expedient to discharge the capacitor 52. For this purpose (Figure 10c), the second switch 58 is operated to connect the first terminal of the capacitor 52 to the ground-reference terminal GND (instant defined by the clock signal CLK = 3). Then, after addressing a new memory cell 12 to be read, step 36 and the following ones of Figure 5 can be carried out.

In particular, Figure 10d (instant CLK = 4), the first switch 56 is operated for connecting the bit lines 17a electrically to the first terminal of the capacitor 52. In this way, the capacitor 52 is charged at a new voltage value $V_{a\_2}$ proportional to the total current $i_{TOT\_2}$ that flows in the bit lines 17a at time CLK = 4. It should be noted that said value $V_{a\_2}$ is equal to the voltage value $V_{b\_1}$ that was supplied to the comparator 50 at the instant CLK = 2 but that had not been stored.

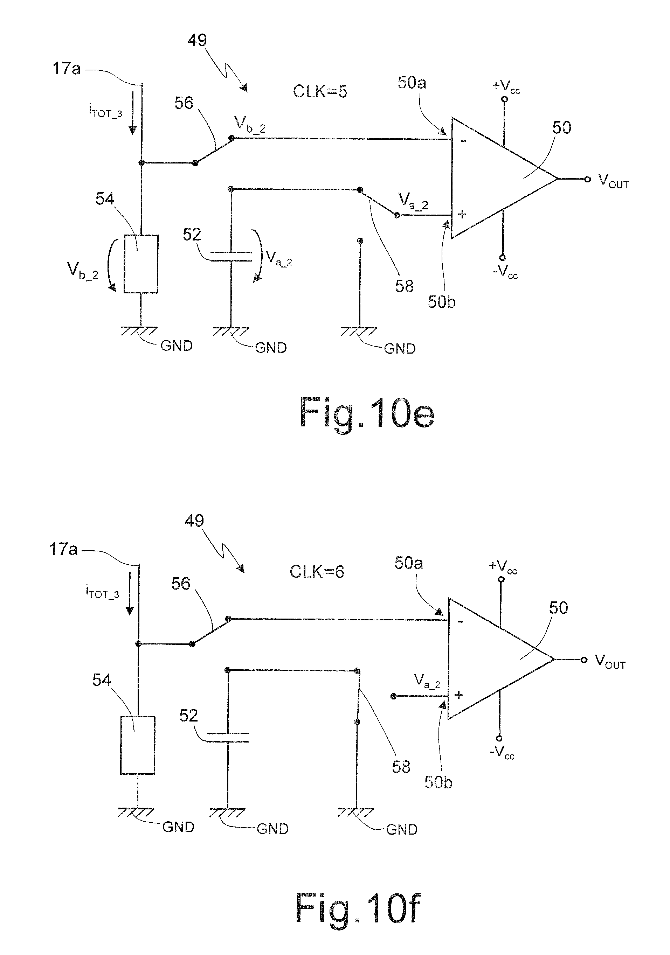

Then, with reference to Figure 10e (instant CLK = 5), the first switch 56 is operated so as to couple the bit lines 17a electrically to the first input 50a of the comparator 50, whilst the second switch 58 is operated so as to couple the first terminal of the capacitor 52 electrically to the second input 50b of the comparator 50, in a way similar to what has already been described with reference to Figure 10b. The voltage value $V_{a\_2}$, proportional to the total current $i_{TOT\_2}$ at time CLK = 4, is compared with the voltage value $V_{b\_2}$ proportional to the total current $i_{TOT\_3}$ at time CLK = 5. The signal $V_{out}$ at output from the comparator 50 is used as described previously for evaluating the logic value of the datum stored in the memory cell 12 that is being read.

Finally (Figure 10f), the capacitor 52 is again discharged by being connected to the ground terminal GND, and acquisition of a new logic datum is carried out.

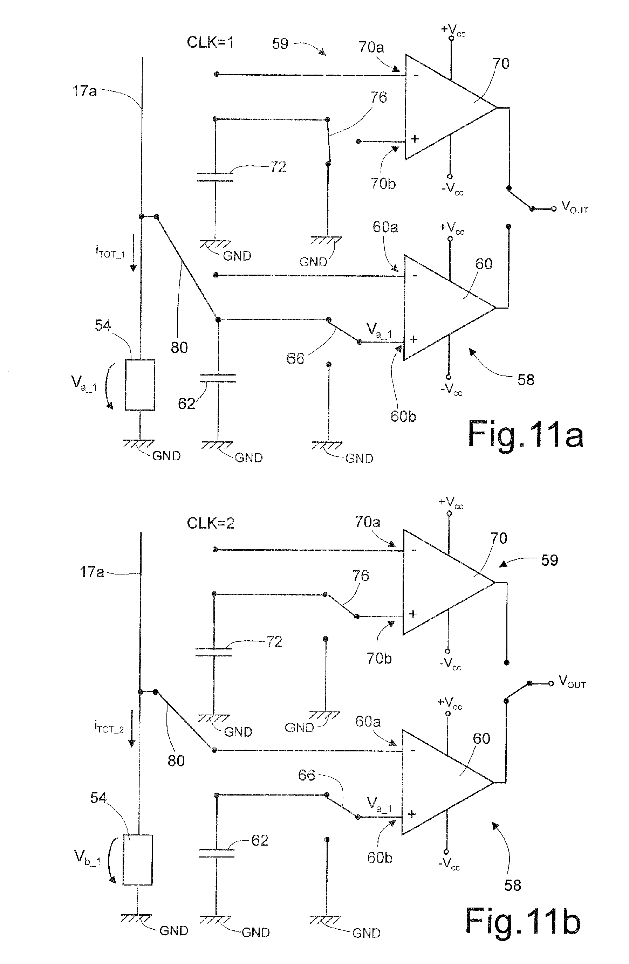

Figures 11a-11d are graphic illustrations of some of the steps of the reading method of Figure 5 (storage and comparison of the voltage values $V_a$ and $V_b$ associated to the values of total current $i_{TOT}$ acquired in successive instants), according to a circuit embodiment alternative to the one shown in Figures 10a-10f.

The embodiment according to Figures 11a-11d comprises two comparison circuits 58 and 59, both of the type shown in Figures 10a-10f, which can be coupled to a single bit lines (also here, by way of example, the bit lines 17a is shown) connected to a ground terminal GND via the resistor 54.

The comparison circuit 58 hence comprises: a comparator 60, having a first input 60a and a second input 60b; a ground-reference terminal GND; a capacitor 62; and a switch 66 (for example, provided in MOS technology). The comparison circuit 59 comprises: a comparator 70, having a first input 70a and a second input 70b; a ground-reference terminal GND; a capacitor 72; and a switch 76 (for example, provided in MOS technology). A further switch 80, which is also, for example, provided in MOS technology, can be operated for connecting the bit lines 17a electrically alternatively to the first input 60a of the comparator 60, to the second input 60b of the comparator 60, to the first input 70a of the comparator 70, and to the second input 70b of the comparator 70.

With reference to Figure 11a, it is assumed that we are at the end of step 34 of Figure 5. In this case, a current $i_{TOT\_1}$ flows in the bit lines 17a. The current $i_{TOT\_1}$ is converted into the voltage value $V_{a\_1}$ by means of the resistor 54 (in a way in itself known).

With reference to Figure 9a, during a first instant defined by a clock CLK (CLK = 1), the switch 80 is operated so as to couple the bit lines 17a electrically to the capacitor 62; the switch 66 is operated so as to couple the capacitor 62 electrically to the second input 60b of the comparator 60. During this step, the capacitor 62 is charged at a voltage $V_{a\_1}$ proportional to the current $i_{TOT\_1}$ that flows in the bit lines 17a ($V_{a\_1} = R \cdot i_{TOT\_1}$). In this way, step 37 of Figure 5 is completed.

Then, step 38 of Figure 5 is carried out, and control goes to step 40. During this step, a voltage value $V_{b\_1}$ is generated proportional to the current $i_{TOT-2}$ that flows in the bit lines 17a ($V_{b\_1} = R \cdot i_{TOT\_2}$ at the time defined by the clock signal CLK = 2).

Next, the comparison described by steps 41-44 of Figure 5 is carried out. With reference to Figure 11b, the switch 80 is operated so as to couple the bit lines 17a electrically to the first input 60a of the comparator 60, whilst the switch 66 is operated so as to couple the capacitor 62 electrically to the second input 60b of the comparator 60. The voltage value $V_{a\_1}$ proportional to the total current $i_{TOT\_1}$ (acquired at the instant CLK = 1) is compared with the voltage value $V_{b\_1}$ proportional to the total current $i_{TOT\_2}$ at the instant CLK = 2. The signal $V_{out}$ at output from the comparator 60 is used as described previously for evaluating the logic value of the datum stored in the memory cell 12 that is being read.

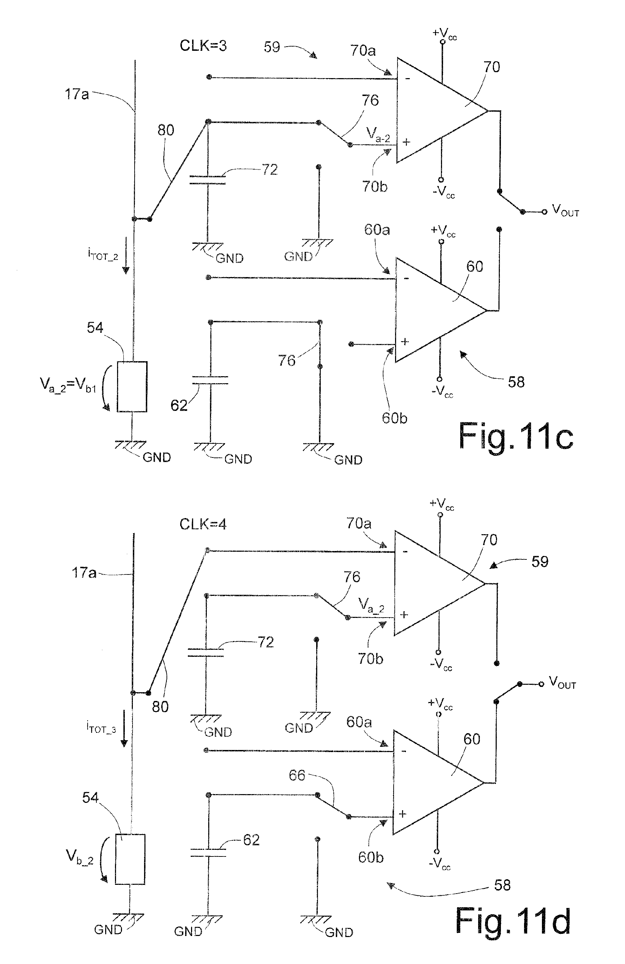

To carry out reading of a new memory cell 12, as already seen previously, it is expedient to discharge the capacitor 62. For this purpose (Figure 11c), the switch 76 is operated for connecting the capacitor 72 to the ground-reference terminal GND (instant defined by the clock signal CLK = 3). Simultaneously, reading of a new memory cell 12 can be performed, by following again step 36 and the following ones of Figure 5.

As shown in Figures 11c and 11d, said acquisition is carried out by the comparison circuit 59 in two successive instants CLK = 3 (storage of the voltage value in the capacitor 72) and CLK = 4 (comparison by means of the comparator 70).

Using the circuit of Figures 11a-11d a considerable advantage is achieved in terms of time as compared to the use of the circuit according to Figures 10a-10f, at the expense of a greater occupation of area.

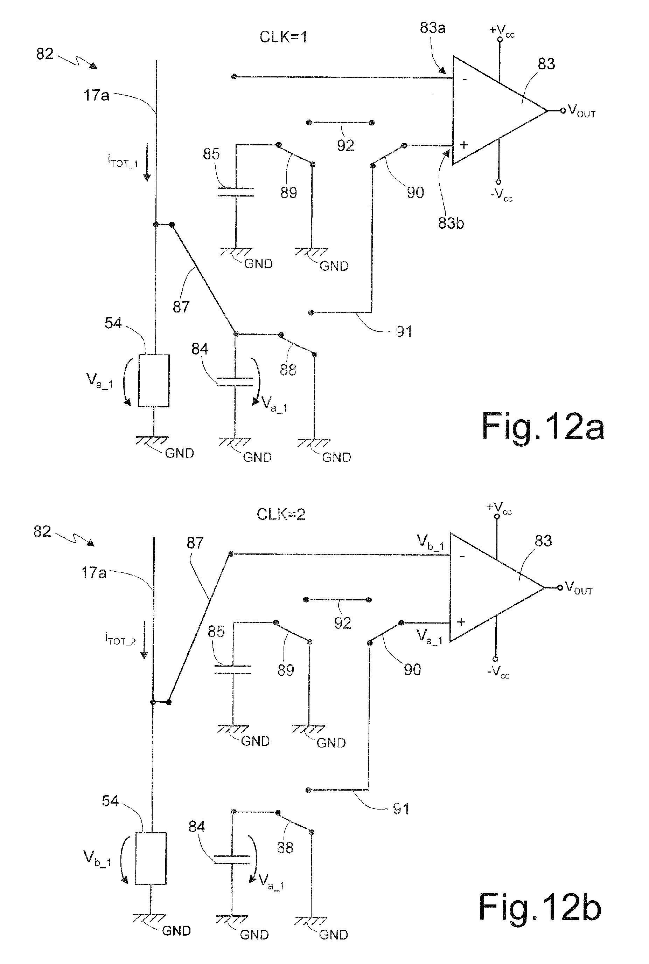

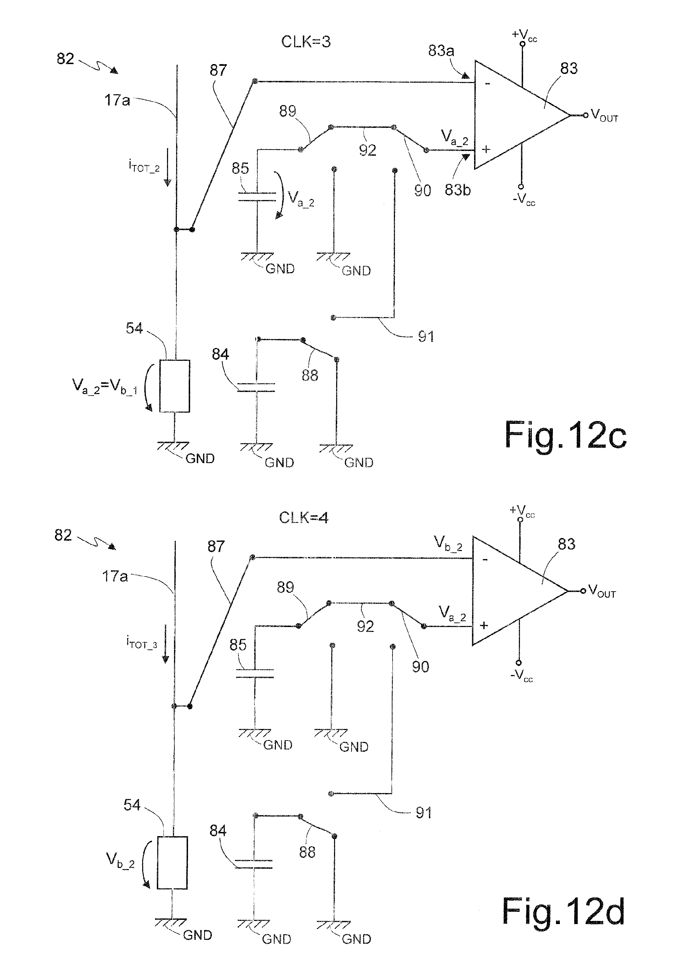

Figures 12a-12d show a comparator circuit 82 according to an embodiment alternative to the ones shown in Figures 10a-10f and 11a-11d.

According to the embodiment of Figures 12a-12d, the comparator circuit 82 comprises: a single comparator 83 having a first input 83a and a second input 83b; a ground-reference terminal GND; a first capacitor 84 and a second capacitor 85; the resistor 54 having resistance R (as already said, of a value chosen appropriately according to the currents considered and to the application), connected between a bit lines (according to the previous examples, the bit lines 17a) and the ground reference GND; a first switch 87 that can be operated for coupling alternatively the bit lines 17a to a first terminal of the first capacitor 84, to a first terminal of the second capacitor 85, or to the first input 83a of the comparator 83; a second switch 88 that can be operated for connecting alternatively the first terminal of the first capacitor 84 to the ground-reference terminal GND, or to a first intermediate circuit portion 91; a third switch 89 that can be operated for connecting alternatively the first terminal of the capacitor 85 to the ground-reference terminal GND and to a second intermediate circuit portion 92; and a fourth switch 90, which is coupled to the second input 83b of the comparator 83 and can be operated for coupling alternatively the second input 83b of the comparator 83 to the first intermediate circuit portion 91 and to the second intermediate circuit portion 92. The operations of switching of the first, second, third, and fourth switches 87, 88, 89, 90 are carried out at a rate defined by a clock signal CLK. The switches 87, 88, 89, 90 are, for example, formed in bipolar or CMOS technology, but other technologies may equally be adopted.

The operations of the comparator circuit 82 are similar to what has been previously described with reference to Figures 10a-10f and 11a-11d, and are illustrated briefly hereinafter. It is assumed that we are the end of step 34 of Figure 5. In this case, a current $i_{TOT\_1}$ flows in the bit lines 17a. The current $i_{TOT\_1}$ is converted into the voltage value $V_{a\_1}$ by means of the resistor 54 (in a way in itself known). The first switch 87 is operated so as to couple electrically the bit lines 17a to the first terminal of the capacitor 84; the second switch 88 is operated so as to couple electrically the first terminal of the capacitor 84 to the first intermediate circuit portion 91; and the fourth switch 90 is operated so as to couple electrically the first intermediate circuit portion 91 to the second input 83b of the comparator 83. In this way, during the time CLK = 1, the voltage $V_{a\_1}$ is supplied at input to the comparator 83 through the second input 83b, and the capacitor 84 is charged to the voltage value $V_{a\_1}$, proportional to the current $i_{TOT\_1}$ that flows in the bit lines 17a ($V_{a\_1} = R \cdot i_{TOT\_1}$). Step 37 of Figure 5 is thus completed.

Then, step 38 of Figure 5 is carried out, and control goes to step 40. During this step (Figure 12b) a voltage value $V_{b\_1}$ is generated proportional to the current $i_{TOT\_2}$ that flows in the bit lines 17a ($V_{b\_1} = R \cdot i_{TOT\_2}$ at the time defined by the clock signal CLK = 2). The first switch 87 is operated in such a way as to couple electrically the bit lines 17a to the first input 83a of the comparator 83 so that the voltage $V_{b\_1}$ is supplied to the input 83a of the comparator 83 to be compared with the voltage $V_{a\_1}$ present on the second input 83b of the comparator 83.

Next, the comparison described by steps 41-44 of Figure 5 is carried out. The signal Vout at output from the comparator 83 is used as described previously to evaluate the logic value of the datum stored in the memory cell 12 that is being read. To proceed to reading of a new memory cell 12, as already seen previously, it is expedient to discharge the capacitor 84. For this purpose (Figure 12c, time CLK = 3), the switch 88 is operated for connecting the capacitor 84 to the ground-reference terminal GND. Simultaneously, storage of the voltage value $V_{a\_2} = V_{b\_1}$ can be carried out. The first switch 87 is operated for coupling the bit lines 17a electrically to the first terminal of the capacitor 85. The third and fourth switches 89, 90 are operated for connecting the first terminal of the capacitor 85 to the second input 83b of the comparator 83. In this way, the capacitor 85 is charged to the voltage value $V_{a\_2} = V_{b\_1}$, which is supplied to the second input 83b of the comparator 83.

Then, step 38 of Figure 5 is carried out again, and control goes to step 40. During this step (Figure 12c) a voltage value $V_{b\_2}$ is generated proportional to the current $i_{TOT-3}$ that flows in the bit lines 17a ($V_{b\_2} = R \cdot i_{TOT\_3}$ at the time defined by the clock signal CLK = 4). The first switch 87 is operated in such a way as to couple electrically the bit lines 17a to the first input 83a of the comparator 83 so that the voltage $V_{b\_2}$ is supplied to the input 83a of the comparator 83 to be compared with the voltage $V_{a\_2}$ present on the second input 83b of the comparator 83.

Next, the comparison described by steps 41-44 of Figure 5 is carried out. The output signal Vout from the comparator 83 is used for evaluating the logic value of the datum stored in the memory cell 12 that is being read.

The comparator circuit 82 is not advantageous in terms of speed as compared to the embodiment of Figures 10a-10d, but offers a saving of area given the use of a single comparator 83.

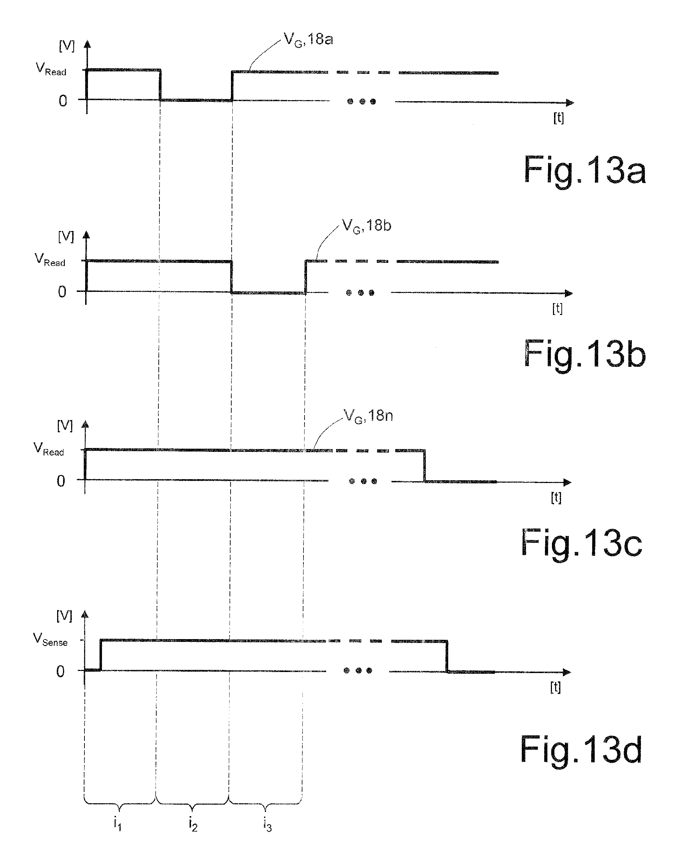

Figures 13a-13d show one embodiment of the present invention alternative to the one shown in Figures 9a-9d.

In particular, according to the embodiment of Figures 13a-13d, at the end of the step of reading of each memory cell 12, the voltage $V_G$ applied to the respective word line is not kept at the reference value (0 V according to the example shown), but is brought back to the value $V_G$ = Vread. Hence (Figure 13a, time interval $i_1$), all the word lines 18a-n are biased at voltage Vread. The total current $i_{TOT}$ is acquired. During the time interval $i_2$, the word line 18a is biased at voltage $V_G$ = 0 V, whilst the remaining word lines are biased at voltage Vread, and a new current $i_{TOT}$ is acquired. The logic datum stored in the memory cell corresponding to the word line 18a is read, as in the case of the method already described, by comparing the values of total current $i_{TOT}$ acquired during the time intervals $i_1$ and $i_2$. Then, at the end of the interval $i_2$, the word line 18a is biased again to the voltage Vread, and the word line 18b is biased to the voltage 0 V, for the duration of the time interval i3. Reading of the logic datum stored in the memory cell 12 corresponding to the word line 18b is made by comparing the value of total current $i_{TOT}$ acquired during the interval $i_3$ with the value of total current $i_{TOT}$ acquired during the interval $i_2$. Then, the biasing voltage of the word line 18b is brought back to Vread. The procedure is repeated in this way up to completion of reading of the column. The voltage Vsense applied between the bit liness of the column considered is applied for the entire duration of the operation of reading of the column. The duration of the intervals $i_2$ and $i_3$ varies according to the speed of the hardware used for reading the total current $i_{TOT}$. This embodiment of the present invention presents the advantage of simplifying considerably the circuitry used for the steps of comparison of the values of total current $i_{TOT}$ acquired.

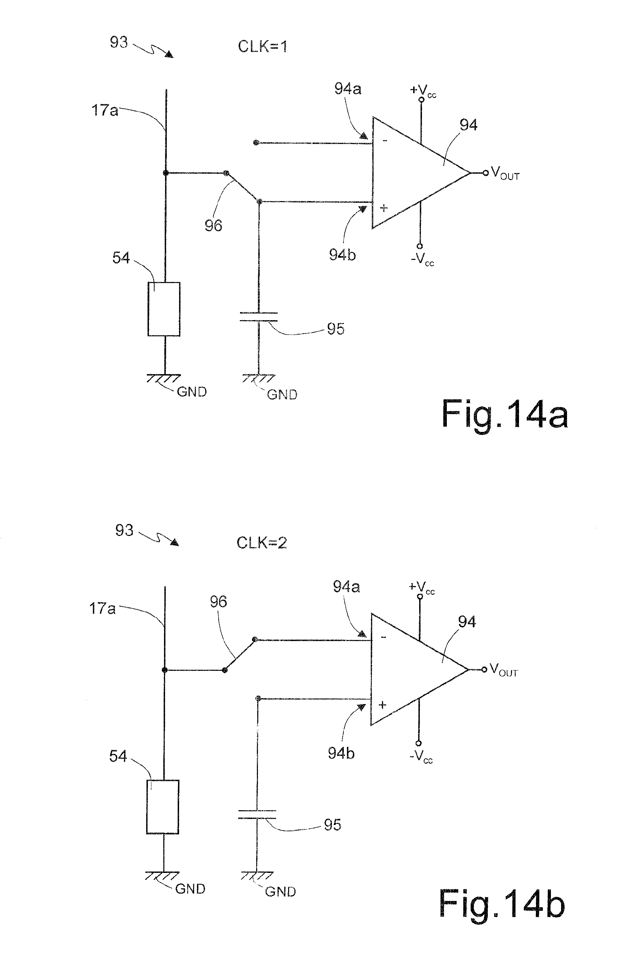

A comparator circuit 93 that can be used according to the method of Figures 13a-13d is shown in Figures 14a and 14b. The comparator circuit 93 is, by way of example, connected to the bit lines 17a.

The comparator circuit 93 comprises: a comparator 94, having a first input 94a and a second input 94b; a capacitor 95, having a first terminal and a second terminal, where the second terminal is connected to a ground reference GND; the resistor 54, having resistance R (of a value chosen appropriately according to the currents considered and to the application), connected between the bit lines 17a and the ground reference GND; and a switch 96, which can be operated for coupling the bit lines 17a to the first terminal of the capacitor 95 and, alternatively, to the first input 94a of the comparator 94.

According to this embodiment, the total current $i_{TOT}$ (but for tolerance errors) may assume for each column 15a-m only two possible values. The first value is the one associated to the pre-charging state (interval $i_1$ with reference to Figures 13a-13d), which is stored (after prior conversion into a voltage value) in the capacitor 95 and then supplied to the second input 94b of the comparator 94 (Figure 14a, CLK = 1). After the pre-charging step, the switch 96 switches onto the first input 94a of the comparator 94 (Figure 14b), until reading of all the memory cells 12 belonging to the column 15a-m considered is completed.

The second admissible value for the total current $i_{TOT}$ is associated to reading of a memory cell 12 biased at $V_G$ = 0 V and containing the logic value "1". For what has been set forth previously. the difference between the two possible levels of current is equal to $\Delta i$. When, for a memory cell 12 addressed and biased at the voltage $V_G$=0V, the comparator 94 were not to supply at output a signal that can be associated to a variation of voltage proportional to the aforesaid variation of current $\Delta i$, then the information contained in said memory cell 12 would be equal to the logic value "0". Otherwise, the logic value would be equal to "1". At the end of the cycle of reading of a column 15a-n the capacitor 95 is to be discharged to ground GND (not shown in the figure).

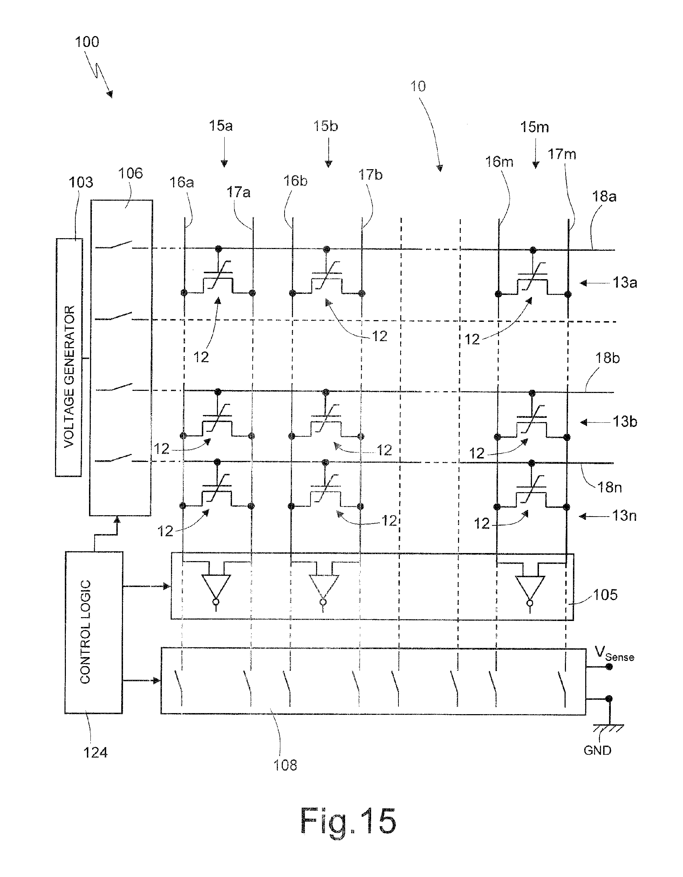

Figure 15 shows a memory block 100, which comprises the memory portion 10 of Figure 2 and the comparison circuit according to Figures 10a-10f or 11a-11d or 12a-12d.

The memory block 100 further comprises a row selector 106, connected to the word lines 18a-n of each row 13a-n, which is designed to connect appropriately the word lines to a voltage-generator block 103 or to ground reference voltage GND in order to bias, according to the steps of the method of Figure 5, the word lines 18a-n at the operating voltages.

For the column 15a-m that is to be read, the current $i_{TOT}$ is supplied at input to a respective detection and comparison circuit 105. In particular, each detection and comparison circuit 105 comprises one or more sense amplifiers designed to operate as described with reference to Figures 10a-10f, or 11a-11d, or 12a-12d, or according to the alternative reading method shown in Figures 13a-13d and 14a, 14b and described with reference to said figures. The voltage signal Vout at output from the sense amplifier is supplied at input to a control logic 124, so as to be processed.

Biasing of the bit liness 16a-m, 17a-m is carried out using a column selector 108 (for example, of the type shown in Figure 15 and described with reference to said figure).

As has been said, the control logic 124 is configured for receiving the output voltage signal Vout of the sense amplifier and identifying, on the basis of said signal, the value of the logic datum stored in the memory cell 12 that is being read.

The control logic 124 is moreover operatively connected to the row and column selectors 106, 108 for controlling their operation in order to implement the reading method according to the present invention.

It is evident that solutions alternative to the one shown in the figure are possible. For example, it is possible to use a single detection and comparison circuit 105, which can be controlled so as to be coupled, alternatively, to just one of the columns 15a-m of the memory portion 10. In this case, a multiplexer is set (in a way not shown) between the memory portion 10 and the single detection and comparison circuit 105.

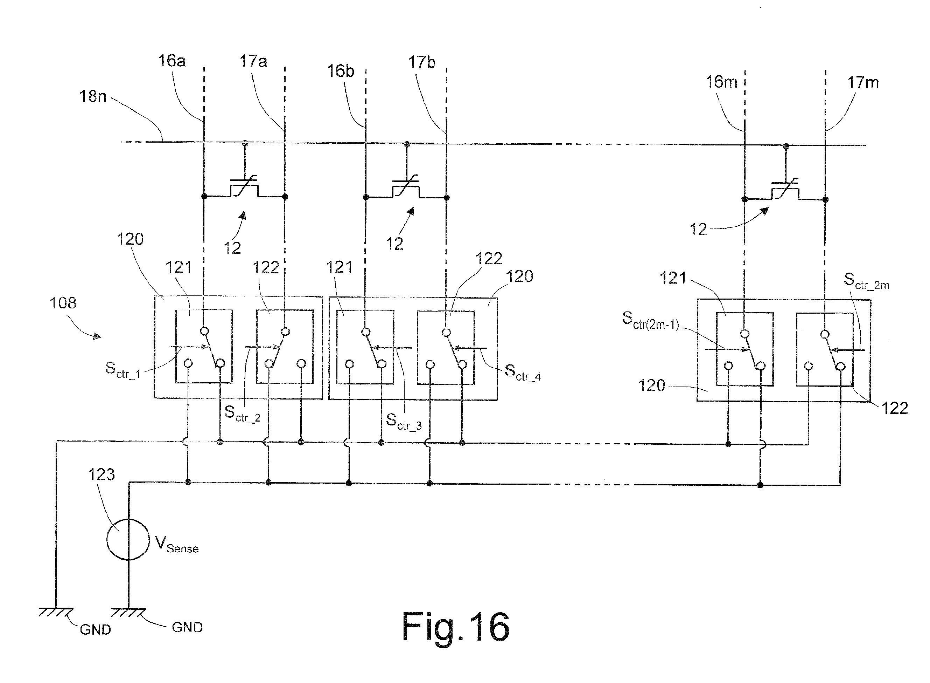

Figure 16 is a schematic illustration of a connection topology that can be used for implementing the column selector 108 (and, in a similar way, the row selector 106), in particular for connecting the bit liness to the operating voltage Vsense and ground reference voltage GND.

Figure 16 shows, in particular, a portion of the column selector 108 comprising, for example, analog switches, even in greater detail, single-pole double-throw (SPDT) switches (of a known type). The latter, according to the convenience of design, can be integrated in pairs (DPDT - double pole double throw, of a known type), in sets of three, or in sets of four in one and the same device.

By way of example, the column selector 108 comprises a DPDT-switch block 120 coupled to each pair of bit liness 16a-m, 17a-m. Each DPDT-switch block 120 comprises two SPDT-switch sub-blocks 121 and 122, each of which is coupled to one of the bit liness 16a-m, 17a-m and is configured for coupling the respective bit lines 16a-m, 17a-m alternatively to a voltage generator 123 designed to generate the voltage Vsense and to a ground reference GND. The ground reference can, in general, be replaced by a generator designed to generate a reference voltage Vref different from the ground voltage. In a simple embodiment, each SPDT-switch block 121, 122 comprises a switch configured for being controlled in switching by means of a respective external signal $S_{ctr\_1}$, $S_{ctr-2}$, ..., $S_{ctr\_2m}$, generated by the control logic 124.

From an examination of the characteristics of the invention provided according to the present disclosure the advantages that it affords are evident.

In particular, the reading operation described is non-destructive, in so far as it is based upon the application of reading pulses with amplitude lower than the coercive voltage of the ferroelectric material so that the polarization of the material returns into the starting stable state once the operation of reading of the data has terminated. Given that the reading operation does not cause erasure of the data stored, the presence of a data-storage buffer and re-writing of the data read is not necessary.

Finally, it is clear that modifications and variations may be made to what has been described and illustrated herein, without thereby departing from the sphere of protection of the present invention, as defined in the annexed claims.

For example, the reading step can be carried out in a way similar to what has been described using a negative voltage Vread, and hence operating on the rising portion of the hysteresis curve.

In addition, it is possible to implement the reading method according to the present invention by replacing the voltage $V_G$ = Vread with the voltage $V_G$ = 0 V, and vice versa. The method in fact remains in general valid applying to the word lines 18a-n the voltages $V_G$ = Vread and $V_G$ = 0 V in a complementary way, indifferently. The voltage $V_G$ = 0 V can be replaced by a reference voltage different from 0 V, for example comprised in the neighbourhood of 0 V, or some other value deemed expedient.

## Claims

1. A method for non-destructive reading of an information datum stored in a memory (10) that includes a first word line (18a), a first bit liness (16a), a second bit liness (17a), and a first ferroelectric transistor (14), which has a first conduction terminal (20a) coupled to the first bit lines, a second conduction terminal (20b) coupled to the second bit lines (17a), and a control terminal (20c) coupled to the first word line, and includes a layer of ferroelectric material (26) in a stable state of polarization that can be associated to a high logic value or a low logic value of the information datum, the method comprising the steps of:

    - applying to the first word line (18a) a first writing electric quantity (Vread) to bias the control terminal (20c) of the first ferroelectric transistor at a first biasing value (Vread) such as not to cause a variation of the stable state of polarization of the layer of ferroelectric material (26);
    - generating a first difference of potential (Vsense) between the first and second bit liness (16a, 17a);
    - generating a first output electric quantity ($i_{TOT}$; $V_a$) indicating a current that flows between the first and second bit liness (16a, 17a) during application of said first reading electric quantity and of said first difference of potential (Vsense);
    - applying to the first word line (18a) a second reading electric quantity ($V_{ref}$) to bias the control terminal (20c) of the first ferroelectric transistor at a second biasing value ($V_{ref}$), different from the first biasing value (Vread) and such as not to cause a variation of the stable state of polarization of the layer of ferroelectric material (26);
    - generating a second difference of potential (Vsense) between the first and second bit liness (16a, 17a);
    - generating a second output electric quantity ($i_{TOT}$; $V_b$) indicating a current that flows between the first and second bit liness (16a, 17a) during application of said second reading electric quantity and of said second difference of potential (Vsense);

- comparing the first and second output electrical quantities ($V_a$, $V_b$) with one another; and
- on the basis of a result of said comparison, determining the logic value of the information datum.

2. The method according to claim 1, wherein the ferroelectric transistor (14) has a hysteretic behaviour of the output current curve, application of the first reading electric quantity (Vread) determining a displacement of the value of output current along said curve, the steps of comparing the first and the second output electrical quantities ($V_a$, $V_b$) with one another and of determining the logic value of the information datum comprising:

- evaluating the degree of said displacement of the value of output current along said curve; and
- associating said degree to a high logic value or a low logic value.

3. The method according to claim 1 or claim 2, wherein the second difference of potential (Vsense) has a value proportional to the value of the first difference of potential, in particular the same value.

4. The method according to any one of the preceding claims, wherein said memory (10) comprises a second word line (18b) and a second ferroelectric transistor (14), which has a first conduction terminal (20a) coupled to the first bit lines, a second conduction terminal (20b) coupled to the second bit lines and a control terminal (20c) coupled to the second word line, and includes a layer of ferroelectric material (26) in a respective stable state of polarization that can be associated to a high logic value or a low logic value, the method further comprising the step of:

- applying to the second word line (18b) the first reading electric quantity (Vread) to bias the control terminal (20c) of the second ferroelectric transistor at the first biasing value (Vread) such as not to cause a variation of the stable state of polarization of the layer of ferroelectric material (26) of the second ferroelectric transistor.

5. The method according to any one of the preceding claims, wherein the first and second reading electrical quantities are voltages.

6. The method according to any one of the preceding claims, wherein the steps of generating the first and second output electrical quantities ($i_{TOT}$, $V_a$; $V_b$) comprise detecting a respective total current ($i_{TOT}$) that flows between the first and second bit liness (16a, 17a) and converting each respective total current ($i_{TOT}$) into a respective corresponding voltage value ($V_a$; $V_b$).

7. A ferroelectric memory, comprising:

- a first word line (18a);
- a first bit lines (16a) and a second bit lines (17a);
- a first ferroelectric transistor (14), which is provided with a layer of ferroelectric material (26) in a stable state of polarization that can be associated to a high logic value or a low logic value of an information datum, and has a first conduction terminal (20a) coupled to the first bit lines, a second conduction terminal which can be associated to the second bit lines (20b), and a control terminal (20c) coupled to the first word line;
- a first generator of a first reading electric quantity (Vread), coupled to the first word line (18a), configured for biasing, via said first word line (18a), the control terminal (20c) of the first ferroelectric transistor (14) at a first biasing value such as not to cause a variation of the stable state of polarization of the layer of ferroelectric material (26) of the first ferroelectric transistor;
- a second generator (40) of a first sensing electric quantity (Vsense) connected between the first and second bit liness (16a, 17a) and configured for generating a first difference of potential between the first and second bit liness;
- a first reading circuit, coupled to the first bit lines and/or to the second bit lines and configured for generating a first output electric quantity ($i_{TOT}$; $V_a$) indicating a current that flows between the first and second bit liness (16a, 17a) during application of said first reading electric quantity and of said first sensing electric quantity (Vsense);
- a third generator of a second reading electric quantity ($V_{ref}$), coupled to the first word line (18a), configured for biasing, via said first word line (18a), the control terminal (20c) of the first ferroelectric transistor (14) at a second biasing value ($V_{ref}$), different from the first biasing value (Vread) and such as not to cause a variation of the stable state of polarization of the layer of ferroelectric material (26) of the first ferroelectric transistor;
- a fourth generator (40) of a second sensing electric quantity (Vsense), connected between the first and second bit liness (16a, 17a) and configured for generating a second difference of potential between the first and second bit liness;
- a second reading circuit, coupled to the first bit lines and/or to the second bit lines, and configured for generating a second output electric quantity ($i_{TOT}$; $V_b$) indicating a current that flows between the first and second bit liness (16a, 17a) during application of said second reading electric quantity and of said second sensing electric quantity (Vsense);

- a comparison circuit, which is coupled to the first and second reading circuits for receiving the first and second output electrical quantities ($V_a$, $V_b$) and is configured for comparing the first and second output electrical quantities with one another and generating a result of the comparison; and

- a control logic, coupled to the comparison circuit and configured for determining the logic value of the information datum on the basis of the result of the comparison.

8. The memory according to claim 7, wherein the ferroelectric transistor (14) has a hysteretic behaviour of the output current curve, the application of the first reading electric quantity (Vread) determining a displacement of the value of output current along said curve, the comparison circuit and the control logic being moreover configured for:

    - evaluating the degree of said displacement of the value of output current along said curve; and
    - associating said degree to a high logic value or a low logic value.

9. The memory according to claim 7 or claim 8, wherein the second difference of potential (Vsense) has a value proportional to the value of the first difference of potential, in particular the same value.

10. The memory according to any one of the preceding claims, further comprising:

    - a second word line (18b) and a second ferroelectric transistor (14), which has a first conduction terminal (20a) coupled to the first bit lines, a second conduction terminal (20b) coupled to the second bit lines, and a control terminal (20c) coupled to the second word line, and includes a layer of ferroelectric material (26) in a respective stable state of polarization that can be associated to a high logic value or a low logic value; and
    - a fifth generator coupled to the second word line (18b), configured for biasing, via said second word line (18b) the control terminal (20c) of the second ferroelectric transistor at the first biasing value (Vread), said first biasing value being such as not to cause a variation of the stable state of polarization of the layer of ferroelectric material (26) of the second ferroelectric transistor.

Fig.1

Fig.2

Fig.3a

Fig.3b

Fig.3c

Fig.4

Fig.5

Fig.6

Fig.7a

Fig.7b

Fig.8

[V]

$V_{Read}$

0

$V_G$,18a

[t]

## Fig.9a

[V]

$V_{Read}$

0

$V_G$,18b

[t]

## Fig.9b

[V]

$V_{Read}$

0

$V_G$,18n

• • •

[t]

## Fig.9c

[V]

$V_{Sense}$

0

• • •

[t]

## Fig.9d

$\tau_1$     $\tau_2$     $\tau_3$       $\tau_n$

Fig.10a

Fig.10b

Fig.10c

Fig.10d

Fig.10e

Fig.10f

Fig.11a

Fig.11b

Fig.11c

Fig.11d

Fig.12a

Fig.12b

CLK=3

Fig.12c

CLK=4

Fig.12d

[V]

$V_{Read}$

0

$V_G$,18a

[t]

## Fig.13a

[V]

$V_{Read}$

0

$V_G$,18b

[t]

## Fig.13b

[V]

$V_{Read}$

0

$V_G$,18n

[t]

## Fig.13c

[V]

$V_{Sense}$

0

[t]

## Fig.13d

$i_1$   $i_2$   $i_3$

93

CLK=1

17a

94a

+V_{CC}

94

96

−

V_{OUT}

+

94b

−V_{CC}

54

95

GND

GND

# Fig.14a

93

CLK=2

94a

+V_{CC}

96

94

17a

−

V_{OUT}

+

94b

−V_{CC}

54

95

GND

GND

# Fig.14b

Fig.15

Fig.16

Europäisches
Patentamt

European
Patent Office

Office européen
des brevets

## EUROPEAN SEARCH REPORT

Application Number

EP 12 15 3546

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 5 699 290 A (YOO IN-KYEONG [KR]) 16 December 1997 (1997-12-16) * column 1, line 25 - column 2, line 13; figures 1, 2 * ----- | 1,7 | INV. G11C11/22 |

TECHNICAL FIELDS
SEARCHED      (IPC)

G11C

The present search report has been drawn up for all claims

| Place of search | Date of completion of the search | Examiner |
|---|---|---|
| Munich | 3 May 2012 | Harms, Juergen |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

&  : member of the same patent family, corresponding
 document

EPO FORM 1503 03.82 (P04C01)

**ANNEX TO THE EUROPEAN SEARCH REPORT
ON EUROPEAN PATENT APPLICATION NO.**

EP 12 15 3546

This annex lists the patent family members relating to the patent documents cited in the above-mentioned European search report.
The members are as contained in the European Patent Office EDP file on
The European Patent Office is in no way liable for these particulars which are merely given for the purpose of information.

03-05-2012

| Patent document cited in search report | | Publication date | Patent family member(s) | | Publication date |
|---|---|---|---|---|---|
| US 5699290 | A | 16-12-1997 | JP | 3674883 B2 | 27-07-2005 |
| | | | JP | 9008160 A | 10-01-1997 |
| | | | US | 5699290 A | 16-12-1997 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5086412 A
- US 6819583 B
- US 4888733 A
- US 6091621 A
- US 6335550 B

**Non-patent literature cited in the description**

- Terabit inch-2 ferroelectric data storage using scanning nonlinear dielectric microscopy nanodomain engineering system. **CHO et al.** Nanotechnology. Institute of Physics Publishing, 2003, 637-642
- **KATO et al.** 0.18-$\mu$m nondestructive readout FeRAM using charge compensation technique. *IEEE Transactions on electron devices,* December 2005, vol. 52 (12